# FASCICULE DE BREVET EUROPEEN

(11) **EP 3 671 841 B1**
(45) Date de publication et mention de la délivrance du brevet: **08.06.2022**
(21) Numéro de dépôt: 19213992.1
(22) Date de dépôt: 05.12.2019
(51) Int. Cl.: H01L 27/15, H01L 25/16, H01L 33/00, H01L 33/32, H01L 33/38, H01L 33/44, H01L 33/62

(54) **PROCÉDÉ DE FABRICATION D'UN DISPOSITIF OPTOÉLECTRONIQUE COMPRENANT UNE PLURALITÉ DE DIODES**
HERSTELLUNGSVERFAHREN EINER OPTOELEKTRONISCHEN VORRICHTUNG, DIE EINE VIELZAHL VON DIODEN UMFASST
METHOD FOR MANUFACTURING AN OPTOELECTRONIC DEVICE COMPRISING A PLURALITY OF DIODES

(30) Priorité: 19.12.2018 FR 1873315
(43) Date de publication de la demande: 24.06.2020
(73) Titulaire: Commissariat à l'Energie Atomique et aux Energies Alternatives, 75015 Paris (FR)
(72) Inventeur: BATUDE, Perrine, 38054 GRENOBLE CEDEX 9 (FR); BONO, Hubert, 38054 GRENOBLE CEDEX 9 (FR)
(74) Mandataire: Cabinet Beaumont

(56) Documents cités:
- US-A- 5 789 766
- US-A- 5 893 721
- YA-JU LEE ET AL: "Monolithic integration of GaN-based light-emitting diodes and metal-oxide-semiconductor field-effect transistors", OPTICS EXPRESS, vol. 22, no. S6, 20 octobre 2014 (2014-10-20), page A1589, XP055612073, US ISSN: 2161-2072, DOI: 10.1364/OE.22.0A1589

## Description

### Domaine technique

La présente description concerne le domaine des dispositifs optoélectroniques. Elle concerne plus particulièrement un procédé de fabrication d'un dispositif optoélectronique comportant une pluralité de diodes semiconductrices, par exemple au nitrure de gallium, et un circuit électronique de contrôle de ces diodes.

### Technique antérieure

On a déjà proposé un dispositif d'affichage émissif comportant une matrice de diodes électroluminescentes (LED) au nitrure de gallium (GaN), et un circuit de contrôle permettant de commander individuellement les LED pour afficher des images.

Pour réaliser un tel dispositif, on peut prévoir de fabriquer séparément le circuit de contrôle et la matrice de LED, puis de les hybrider, c'est-à-dire de les empiler en les connectant l'un à l'autre.

Un inconvénient de cette méthode de fabrication réside dans la nécessité d'aligner précisément le circuit de contrôle et la matrice de LED lors de l'étape d'assemblage de ces deux éléments, de façon que chaque LED vienne bien se positionner sur un plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels.

Pour pallier cet inconvénient, il a été proposé, dans la demande de brevet internationale WO 2017/194845 A1 déposée par le demandeur le 13 mai 2016, ainsi que dans la demande de brevet français FR 3 073 669 A1 déposée par le demandeur le 10 novembre 2017, de :
- réaliser d'abord le circuit de contrôle sous la forme d'un circuit intégré comportant, sur une face, une pluralité de plots métalliques destinés à être connectés aux LED de façon à permettre de contrôler individuellement le courant circulant dans chaque LED ;
- rapporter ensuite sur la face du circuit de contrôle comportant les plots métalliques un empilement actif de LED s'étendant de façon continue sur toute la surface du circuit de contrôle ; puis
- structurer l'empilement actif de LED pour délimiter et isoler les unes des autres les différentes LED du dispositif.

Un avantage de ce procédé de fabrication est que, lors de l'étape de report de l'empilement actif de LED sur le circuit de contrôle, les positions des différentes LED du dispositif dans l'empilement actif ne sont pas encore définies. Il n'y a par conséquent pas de contrainte forte en termes de précision d'alignement lors du report. La délimitation des différentes LED dans l'empilement actif peut ensuite être réalisée par des procédés de structuration d'un substrat et de dépôt de couches isolantes et conductrices sur un substrat, qui offrent une précision d'alignement nettement supérieure à la précision qui peut être obtenue lors d'un report d'un substrat sur un autre.

Il a par ailleurs été proposé, dans la demande de brevet français FR 3 065 322 A1 déposée par le demandeur le 18 avril 2017, de :
- réaliser une matrice de LED comportant chacune des électrodes accessibles depuis une face arrière de la matrice ;
- rapporter, sur la face arrière de la matrice de LED, un empilement de couches comprenant au moins une couche de semiconducteur, une couche de diélectrique de grille et une couche de matériau conducteur de grille ; puis
- réaliser à partir de l'empilement de couches, un circuit de contrôle couplé aux électrodes des LED.

Là encore, un avantage de ce procédé de fabrication est que, lors de l'étape de report de l'empilement de couches sur la matrice de LED, les positions des composants du circuit de contrôle et des métallisations de connexion du circuit de contrôle à la matrice de LED ne sont pas encore définies. Il n'y a par conséquent pas de contrainte forte en termes de précision d'alignement lors du report. La formation des composants du circuit de contrôle et des métallisations de connexion du circuit de contrôle à la matrice de LED peut ensuite être réalisée par des procédés de fabrication de circuits intégrés, qui offrent une précision d'alignement nettement supérieure à la précision qui peut être obtenue lors d'un report d'un substrat sur un autre.

Par ailleurs, les documents US 5 893 721 A, US 5 789 766 A et "Monolithic intégration of GaN-based light-emitting diodes and metal-oxide-semiconductor field-effect transistors" de Ya-Ju Lee et al., OPTICS EXPRESS, Vol. 22, No. S6 (2014), pages A1589 - A1595, divulguent d'autres procédés de fabrication de matrices de LED monolithiques contrôlées par des transistors.

Il serait toutefois souhaitable d'améliorer au moins en partie certains aspects des procédés de fabrication de dispositifs optoélectroniques décrits dans les documents de l'état de la technique antérieure susmentionnés

### Résumé de l'invention

La présente invention prévoit un procédé de fabrication d'un dispositif optoélectronique conformément à la revendication 1 ci-après, comportant les étapes suivantes :
a) prévoir un empilement actif de diode comportant une première couche semiconductrice dopée d'un premier type de conductivité et une deuxième couche semiconductrice dopée du deuxième type de conductivité, revêtant la face supérieure de la première couche ;
b) disposer une troisième couche semiconductrice sur la face supérieure de l'empilement actif ;
c) après l'étape b), former au moins un transistor MOS dans et sur la troisième couche semiconductrice ; et
d) après l'étape b), avant ou après l'étape c), former des tranchées s'étendant verticalement à travers un plan correspondant à la troisième couche, ou directement à travers la troisième couche, et débouchant dans la première couche, ou sur la face supérieure de la première couche, et délimitant une pluralité de pixels comprenant chacun une diode et une cellule élémentaire de contrôle de la diode.
Les autres modes de réalisation de la présente invention sont l'objet des revendications dépendantes en annexe.

Selon un mode de réalisation, en vue de dessus, les tranchées forment une grille continue séparant les uns des autres les pixels du dispositif.

Selon un mode de réalisation, le procédé comprend en outre une étape de remplissage des tranchées par du métal de façon à former une métallisation de contact avec la première couche semiconductrice, commune à tous les pixels du dispositif.

Selon un mode de réalisation, avant le remplissage des tranchées par du métal, une couche d'isolation est déposée sur les parois latérales des tranchées.

Selon un mode de réalisation, après l'étape b) et avant l'étape d), la troisième couche semiconductrice est retirée dans les zones de formation des tranchées.

Selon un mode de réalisation, la troisième couche semiconductrice n'est pas retirée dans les zones de formation des tranchées avant l'étape d).

Selon un mode de réalisation, le procédé comprend en outre, après l'étape b), une étape de formation, dans chaque pixel, d'une métallisation de contact avec la deuxième couche semiconductrice, et d'une métallisation de contact avec la troisième couche semiconductrice.

Selon un mode de réalisation, la métallisation de contact avec la deuxième couche semiconductrice et la métallisation de contact avec la troisième couche semiconductrice sont des métallisations distinctes, connectées l'une à l'autre par une piste conductrice en contact avec les faces supérieures desdites métallisations.

Selon un mode de réalisation, la métallisation de contact avec la deuxième couche semiconductrice et la métallisation de contact avec la troisième couche conductrice sont confondues et sont disposées dans une même ouverture traversant la troisième couche semiconductrice.

Selon un mode de réalisation, le procédé comprend en outre, après l'étape c), une étape de dépôt d'un empilement métal-isolant-métal, une couche métallique inférieure de l'empilement métal-isolant-métal étant en contact avec une grille conductrice dudit au moins un transistor MOS.

Selon un mode de réalisation, le procédé comprend en outre une étape de formation, dans chaque pixel, d'une métallisation en contact à la fois avec une couche métallique supérieure de l'empilement métal-isolant-métal et avec la troisième couche semiconductrice.

Selon un mode de réalisation, le procédé comprend en outre, avant l'étape c), la formation d'un plan de masse conducteur ou semiconducteur entre la deuxième couche semiconductrice et la troisième couche semiconductrice, le plan de masse étant isolé des deuxième et troisième couches semiconductrices.

Selon un mode de réalisation, le procédé comprend une étape de formation, dans chaque pixel, d'une métallisation de contact avec le plan de masse, ladite métallisation étant disposée dans une ouverture traversant la troisième couche semiconductrice.

Selon un mode de réalisation, les diodes sont des diodes électroluminescentes.

Selon un mode de réalisation, les première et deuxième couches semiconductrices sont des couches à base de matériaux semiconducteurs III-V, et la troisième couche semiconductrice est en silicium.

Selon un mode de réalisation, le procédé comprend en outre, après l'étape c), une étape de disposition d'une quatrième couche semiconductrice sur la face supérieure de la troisième couche semiconductrice.

Selon un mode de réalisation, à l'étape c), la température de formation du transistor MOS ne dépasse pas 500°C.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre une étape d'un procédé de fabrication d'un dispositif optoélectronique selon un mode de réalisation ;
la figure 2 illustre une autre étape d'un procédé de fabrication d'un dispositif optoélectronique selon un mode de réalisation ;
la figure 3 illustre une autre étape d'un procédé de fabrication d'un dispositif optoélectronique selon un mode de réalisation ;
la figure 4 illustre une autre étape d'un procédé de fabrication d'un dispositif optoélectronique selon un mode de réalisation ;
la figure 5 illustre une autre étape d'un procédé de fabrication d'un dispositif optoélectronique selon un mode de réalisation ;
la figure 6 illustre une autre étape d'un procédé de fabrication d'un dispositif optoélectronique selon un mode de réalisation ;
la figure 7 illustre une autre étape d'un procédé de fabrication d'un dispositif optoélectronique selon un mode de réalisation ;
la figure 8 illustre une autre étape d'un procédé de fabrication d'un dispositif optoélectronique selon un mode de réalisation ;
la figure 9 illustre une autre étape d'un procédé de fabrication d'un dispositif optoélectronique selon un mode de réalisation ;
la figure 10 illustre une première variante du procédé des figures 1 à 9 ;
la figure 11 illustre une deuxième variante du procédé des figures 1 à 9 ;
la figure 12 illustre une étape d'une troisième variante du procédé des figures 1 à 9 ;
la figure 13 illustre une autre étape de la troisième variante du procédé des figures 1 à 9 ;
la figure 14 illustre une autre étape de la troisième variante du procédé des figures 1 à 9 ;
la figure 15 illustre une autre étape de la troisième variante du procédé des figures 1 à 9 ;
la figure 16 illustre une autre étape de la troisième variante du procédé des figures 1 à 9 ;
la figure 17 illustre une autre étape de la troisième variante du procédé des figures 1 à 9 ;
la figure 18 illustre une autre étape de la troisième variante du procédé des figures 1 à 9 ; et
la figure 19 illustre une quatrième variante du procédé des figures 1 à 9.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation complète du circuit de contrôle des dispositifs décrits n'a pas été détaillée, la réalisation d'un tel circuit étant à la portée de l'homme du métier à partir des indications de la présente description. De plus, la composition et l'agencement des différentes couches d'un empilement actif de diode semiconductrice n'ont pas été détaillés, les modes de réalisation décrits étant compatibles avec les empilements actifs usuels de diodes semiconductrices, notamment au nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

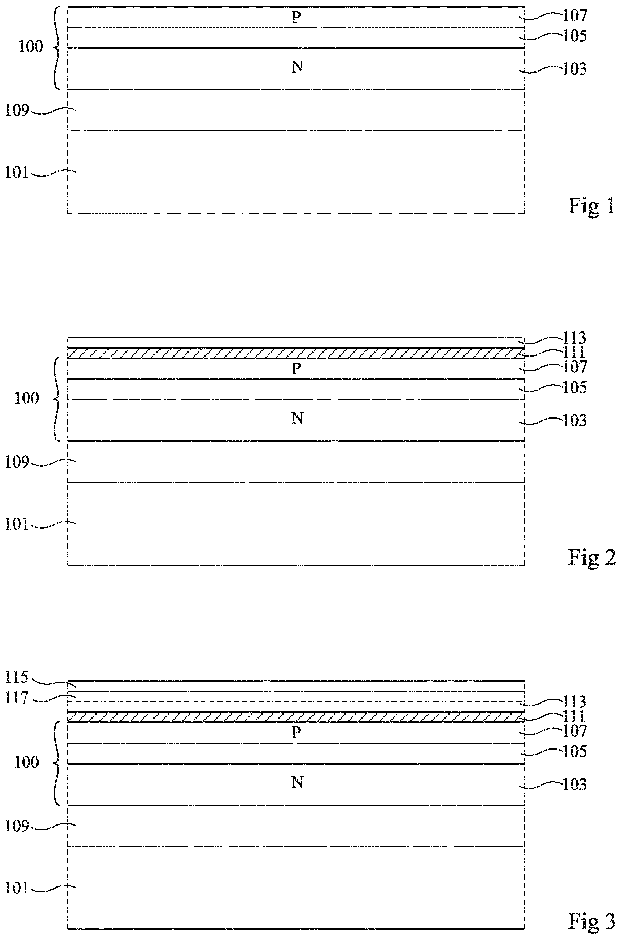

Les figures 1 à 9 sont des vues en coupe illustrant de façon schématique et partielle des étapes successives d'un exemple d'un procédé de fabrication d'un dispositif optoélectronique selon un mode de réalisation. On notera que sur les figures 1 à 9, seul un pixel du dispositif est entièrement représenté, étant entendu que, en pratique, un grand nombre de pixels sont formés simultanément sur un même substrat de support.

La figure 1 représente une structure de départ comportant un empilement actif de LED 100 disposé sur la face supérieure d'un substrat de support 101. Le substrat 101 est par exemple en silicium, en saphir, en corindon, ou en tout autre matériau sur lequel un empilement actif de LED peut être déposé. Dans l'exemple représenté, l'empilement actif 100 comprend, dans l'ordre en partant de la face supérieure du substrat 101, une couche semiconductrice dopée de type N 103, une couche émissive 105, et une couche semiconductrice dopée de type P 107. Les couches semiconductrices 103 et 107 sont par exemple en nitrure de gallium (GaN). La couche émissive 105 est par exemple constituée par un empilement de puits quantiques, par exemple à base de nitrure de gallium et/ou de nitrure d'indium-gallium (InGaN). Dans cet exemple, la face inférieure de la couche émissive 105 est en contact avec la face supérieure de la couche 103, et la face supérieure de la couche émissive 105 est en contact avec la face inférieure de la couche 107. En pratique, selon la nature du substrat 101, un empilement 109 d'une ou plusieurs couches tampon, par exemple à base de nitrure d'aluminium (AIN), de nitrure d'aluminium-gallium (AlGaN) et/ou de nitrure de gallium, peut faire interface entre le substrat de support 101 et la couche 103. L'empilement actif 100 est par exemple formé par épitaxie. A ce stade, chacune des couches 103, 105 et 107 de l'empilement actif 100 s'étend de façon continue et présente une épaisseur sensiblement uniforme sur sensiblement toute la surface du substrat 101. A titre d'exemple, l'épaisseur de la couche semiconductrice 103 est comprise entre 100 nm et 3 µm, par exemple de l'ordre de 700 nm. L'épaisseur de la couche émissive 105 peut être comprise entre 10 et 200 nm, par exemple de l'ordre de 100 nm. L'épaisseur de la couche semiconductrice 107 est par exemple comprise entre 50 et 300 nm, par exemple de l'ordre de 100 nm.

La figure 2 illustre une étape de dépôt d'une couche conductrice de contact 111, par exemple une couche métallique, sur et en contact avec la face supérieure de la couche semiconductrice 107. La couche 111 est par exemple en aluminium. L'épaisseur de la couche 111 est par exemple comprise entre 5 et 200 nm, par exemple de l'ordre de 100 nm.

La figure 2 illustre en outre une étape de dépôt d'une couche diélectrique de collage 113 sur la face supérieure de la couche conductrice 111, par exemple en contact avec la face supérieure de la couche conductrice 111. La couche 113 est par exemple en oxyde de silicium.

A ce stade, chacune des couches 111 et 113 s'étend de façon continue et présente une épaisseur sensiblement uniforme sur sensiblement toute la surface supérieure du substrat 101.

La figure 3 illustre une étape de formation d'une couche semiconductrice cristalline 115, par exemple en silicium, sur la face supérieure de la couche diélectrique 113.

Pour cela, on peut par exemple prévoir un empilement de type semiconducteur sur isolant (SOI), comprenant un substrat de support (non représenté), par exemple en silicium, une couche isolante enterrée (non représentée), par exemple en oxyde de silicium, revêtant une face du substrat de support, et une couche de silicium monocristallin, correspondant à la couche semiconductrice 115, revêtant la face de la couche isolante enterrée opposée au substrat de support. Une couche diélectrique de collage 117, par exemple en le même matériau que la couche diélectrique 113, est d'abord déposée sur la face de la couche semiconductrice 115 opposée à la couche isolante enterrée, puis l'empilement SOI est rapporté sur la face supérieure de la couche 113, de façon à mettre en contact la face de la couche diélectrique 117 opposée à la couche semiconductrice 115 avec la face supérieure de la couche diélectrique 113. On réalise ainsi un collage direct ou collage moléculaire de la couche 117 sur la couche 113, permettant de solidariser l'empilement SOI à la couche 113. Le substrat de support et la couche isolante enterrée de l'empilement SOI sont ensuite retirés de façon à libérer l'accès à la face supérieure de la couche semiconductrice 115.

A titre de variante, on peut partir d'un substrat semiconducteur monocristallin massif (non représenté), par exemple en silicium, dans lequel on vient implanter une couche enterrée d'atomes d'hydrogène. La couche implantée enterrée s'étend de façon continue sur sensiblement toute la surface du substrat et fait interface entre une couche superficielle supérieure du substrat, correspondant à la couche 115, et le reste du substrat. Une couche diélectrique de collage 117, par exemple en le même matériau que la couche diélectrique 113, est déposée sur la face de la couche semiconductrice 115 opposée à la couche implantée enterrée, puis l'ensemble est rapporté sur la face supérieure de la couche 113, de façon à mettre en contact la face de la couche diélectrique 117 opposée à la couche semiconductrice 115 avec la face supérieure de la couche diélectrique 113. On réalise ainsi un collage direct ou collage moléculaire de la couche 117 sur la couche 113, permettant de solidariser le substrat semiconducteur à la couche 113. Le substrat semiconducteur est ensuite fracturé au niveau de la couche implantée enterrée, de façon à ne conserver que la couche semiconductrice 115 au-dessus de l'empilement actif de LED 100.

A titre de variante, la couche 115 peut être formée par dépôt d'une couche d'un matériau semiconducteur amorphe, par exemple du silicium, sur la face supérieure de la couche diélectrique 113, puis recristallisation du matériau amorphe, par exemple par recuit laser, pour obtenir la couche cristalline 115.

A l'issue de l'étape de la figure 3, la couche semiconductrice 115 s'étend de façon continue et présente une épaisseur sensiblement constante sur sensiblement toute la surface supérieure du substrat 101. L'épaisseur de la couche 115 est par exemple comprise entre 5 et 100 nm. L'épaisseur totale de diélectrique entre la couche conductrice 111 et la couche semiconductrice 115, correspondant à la somme des épaisseurs des couches 113 et 117 dans l'exemple représenté, est par exemple comprise entre 10 et 1000 nm.

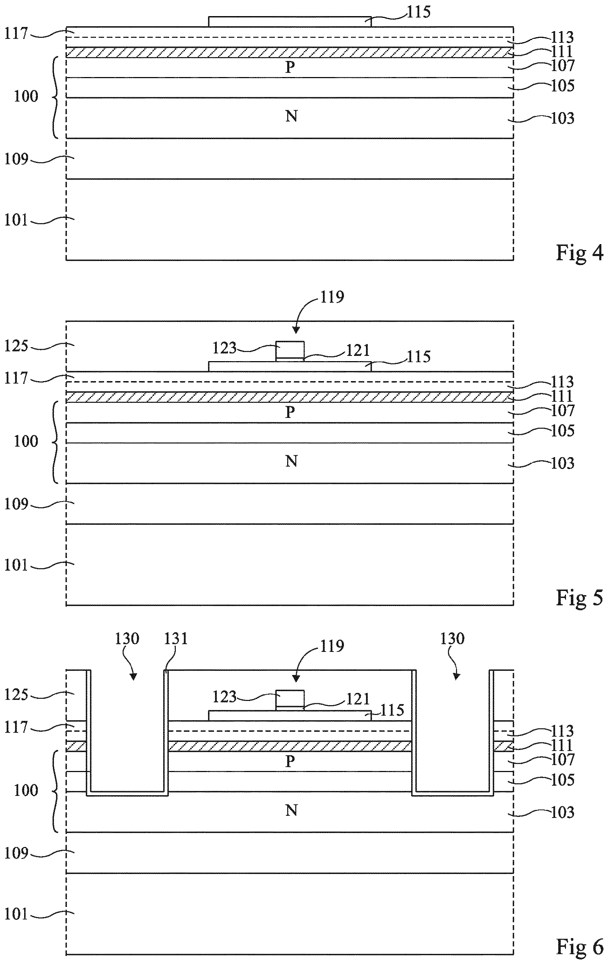

Les figures 4 et 5 illustrent de façon schématique des étapes de fabrication d'un circuit électronique de contrôle dans et sur la couche semiconductrice 115. Le circuit de contrôle comprend, pour chaque pixel du dispositif, une cellule élémentaire de contrôle connectée à la LED du pixel, permettant de contrôler individuellement le courant circulant dans la LED du pixel et donc l'intensité lumineuse émise par la LED du pixel. Chaque cellule élémentaire de contrôle comprend notamment au moins un transistor MOS connecté à une électrode de la LED du pixel. Le schéma électrique du circuit de contrôle n'a pas été représenté et ne sera pas détaillé ici, les modes de réalisation décrits étant compatibles avec tous les schémas électriques connus de circuits électroniques de contrôle d'une matrice de LED.

La figure 4 illustre plus particulièrement une étape de retrait localisé de la couche semiconductrice 115, par exemple par photolithographie et gravure s'interrompant dans ou sur la face supérieure de l'empilement diélectrique 117/113. Cette étape permet notamment de délimiter dans la couche 115, dans chaque pixel du dispositif d'affichage, un ou plusieurs caissons semiconducteurs destinés à contenir chacun un ou plusieurs transistors MOS de la cellule élémentaire de contrôle du pixel.

La figure 5 illustre quant à elle une étape de formation des grilles des transistors MOS du circuit de contrôle. Pour cela, un empilement de grille 119 est formé au-dessus de la région de canal de chacun des transistors MOS du circuit de contrôle. L'empilement de grille 119 comprend une couche d'isolant de grille 121, par exemple en oxyde de silicium, disposée sur et en contact avec la face supérieure de la couche semiconductrice 115, et une couche conductrice 123, par exemple en silicium polycristallin dopé ou en métal, disposée sur et en contact avec la face supérieure de la couche diélectrique 121. L'empilement de grille 119 est par exemple dans un premier temps déposé de façon continue sur toute la surface du substrat 101, puis retiré de façon localisée, par exemple par photolithographie et gravure, en regard des régions de source et de drain des transistors.

On notera que l'ordre des étapes susmentionnées de gravure localisée de la couche semiconductrice 115 (figure 4) et de formation des grilles des transistors (figure 5) peut être inversé. De plus, la réalisation des transistors du circuit de contrôle du dispositif d'affichage peut comprendre des nombreuses autres étapes, non détaillées ici, par exemple d'implantation des régions de source, de drain et/ou de canal des transistors, de réalisation d'espaceurs, de siliciuration de la face supérieure des régions de contact de source, de drain et/ou de grille des transistors, etc. De préférence, les transistors du circuit électronique de contrôle sont réalisés sous un budget thermique limité, pour ne pas risquer d'endommager l'empilement actif de LED 100. A titre d'exemple, les transistors du circuit de contrôle du dispositif sont réalisés par un procédé de fabrication de transistors MOS dit à froid, par exemple tel que la température maximale à laquelle sont soumises les couches de l'empilement actif de LED 100 pendant la fabrication des transistors ne dépasse pas 500°C.

La figure 5 illustre en outre une étape postérieure à la fabrication des transistors MOS du circuit de contrôle, dans laquelle une couche 125 d'un matériau diélectrique est déposée sur la face supérieure de l'assemblage. La couche 125, aussi appelée couche diélectrique pré-métal, s'étend par exemple de façon continue sur sensiblement toute la surface du dispositif. L'épaisseur de la couche 125 est de préférence supérieure à la somme des épaisseurs de la couche semiconductrice 115 et de l'empilement de grille 119. A titre d'exemple, l'épaisseur de la couche 125 est comprise entre 100 nm et 700 nm.

La figure 6 illustre une étape de gravure de tranchées 130 s'étendant verticalement depuis la face supérieure de la couche diélectrique 125 en direction de la face inférieure du substrat. A cette étape, la gravure des tranchées 130 est interrompue dans la couche semiconductrice inférieure 103 de l'empilement actif de LED 100 ou sur la face supérieure de la couche semiconductrice inférieure 103. Les tranchées 130 délimitent des îlots ou mésas correspondant chacun à un pixel du dispositif, étant entendu que chaque pixel comporte une LED commandable individuellement (i.e. indépendamment des autres LED du dispositif) et une cellule élémentaire de contrôle de la LED. Ainsi, les tranchées 130 délimitent, dans l'empilement actif de LED 100, une pluralité de LED commandables individuellement, et, dans l'empilement comportant la couche semiconductrice 115 et les empilements de grilles 119, une pluralité de cellules élémentaires de contrôle correspondantes, chaque cellule élémentaire de contrôle étant destinée à commander la LED sous-jacente. En vue de dessus, les pixels du dispositif peuvent être agencés en matrice, les tranchées 130 formant une grille continue telle que chaque pixel soit entièrement entouré de tranchées 130, et telle que deux pixels voisins soient séparés l'un de l'autre par une tranchée 130.

On notera que dans cet exemple, la couche semiconductrice 115 a préalablement été retirée, lors de l'étape de la figure 4, dans les zones de formation des tranchées 130. La gravure des tranchées 130 ne traverse donc pas la couche semiconductrice 115. Les modes de réalisation décrits ne se limitent toutefois pas à ce cas particulier.

La figure 6 illustre en outre une étape de formation d'espaceurs isolants 131, par exemple en oxyde de silicium ou en nitrure de silicium, sur les parois latérales des tranchées 130. A titre d'exemple, pour former les espaceurs 131, une couche d'un matériau isolant est d'abord déposée de façon continue sur toute la surface supérieure de l'assemblage, par exemple par une méthode de dépôt conforme, puis les parties horizontales de la couche isolante sont retirées, par exemple par gravure anisotrope verticale, de façon à conserver uniquement les portions de la couche isolante situées sur les parois latérales des tranchées, ces portions formant les espaceurs 131.

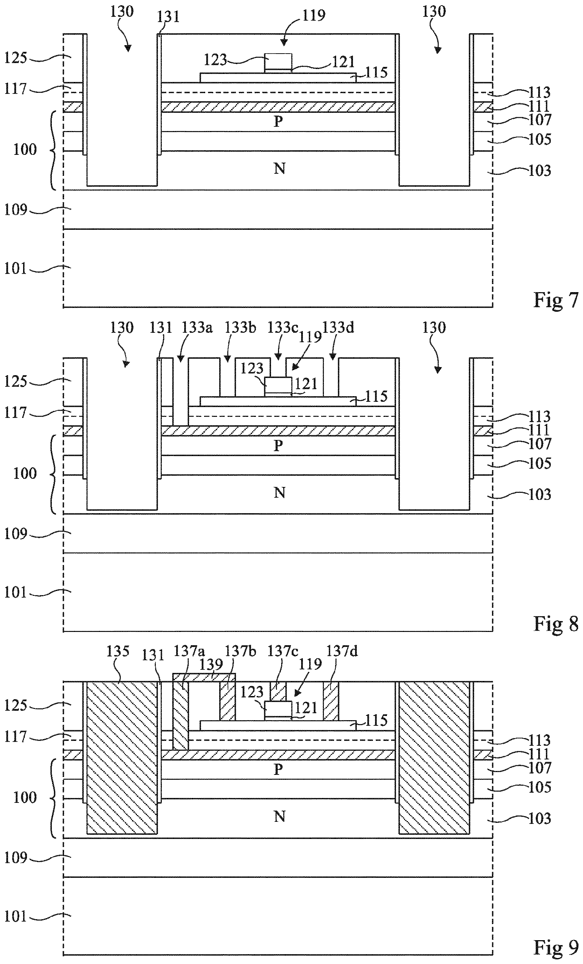

La figure 7 illustre une étape de prolongement des tranchées 130 dans la couche semiconductrice inférieure 103 de l'empilement de LED. Dans l'exemple représenté, la gravure est interrompue avant d'atteindre la face inférieure de la couche 103, c'est-à-dire que les tranchées 130 ne traversent pas entièrement la couche 103. A titre de variante, les tranchées 130 peuvent traverser entièrement la couche 103. Lors de cette étape, les flancs de la couche conductrice de contact d'anode 111 et des couches 107 et 105 sont protégés de la gravure par les espaceurs 131.

La figure 8 illustre une étape de formation, dans chaque pixel du dispositif, d'ouvertures de reprise de contact s'étendant verticalement depuis la face supérieure de la couche diélectrique 125 en direction de la face inférieure du substrat, et débouchant sur des régions de contact de source, de grille et de drain des transistors MOS et sur la couche conductrice de contact d'anode 111 du pixel. Dans l'exemple de la figure 8, on a représenté plus particulièrement, dans chaque pixel, une ouverture 133a débouchant sur la face supérieure de la couche de contact d'anode 111 du pixel, une ouverture 133b débouchant sur la face supérieure de la couche semiconductrice 115, sur une première région de conduction (source ou drain) d'un transistor MOS du pixel, une ouverture 133c débouchant sur la face supérieure de la couche conductrice de grille 123 d'un transistor MOS du pixel, et une ouverture 133d débouchant sur la face supérieure de la couche semiconductrice 115, sur une deuxième région de conduction (drain ou source) d'un transistor MOS du pixel.

Les ouvertures 133a, 133b, 133c, 133d peuvent être formées lors d'une même étape de photolithographie et gravure. Les modes de réalisation décrits ne se limitent toutefois pas à ce cas particulier. On notera que dans cet exemple, la couche semiconductrice 115 a préalablement été retirée, lors de l'étape de la figure 4, dans les zones de formation des ouvertures 133a. La gravure des ouvertures 133a ne traverse donc pas la couche semiconductrice 115. Les modes de réalisation décrits ne se limitent toutefois pas à ce cas particulier. Par ailleurs, bien que cela n'apparaisse pas sur les figures, les faces supérieures des zones de reprise de contact de source, de drain, et éventuellement de grille (dans le cas où les grilles sont en silicium polycristallin) des transistors peuvent avoir été préalablement siliciurées lors des étapes de fabrication des figures 4 et 5, ce qui permet de faciliter l'arrêt de la gravure des ouvertures 133b, 133c et 133d, et de réduire les résistances d'accès aux régions de source, de drain, et, le cas échéant, de grille des transistors.

La figure 9 illustre une étape de remplissage des tranchées 130 par du métal, par exemple du cuivre, de façon à former une métallisation de contact de cathode 135 commune à toutes les LED du dispositif d'affichage. Dans cet exemple, les tranchées sont entièrement comblées par la métallisation 135. La métallisation 135 est en contact avec la couche 103 au fond et sur une partie inférieure des parois latérales des tranchées 130. La métallisation 135 est en revanche isolée des couches 105, 107 et 111 par les espaceurs 131.

La figure 9 illustre en outre une étape de remplissage des ouvertures 133a, 133b, 133c et 133d par du métal, par exemple du tungstène, de façon à former :
- dans chaque ouverture 133a, une métallisation de contact d'anode 137a spécifique à la LED sous-jacente,
- dans chaque ouverture 133b, une métallisation de contact de source ou de drain 137b spécifique au transistor sous-jacent ;
- dans chaque ouverture 133c, une métallisation de contact de grille 137c spécifique au transistor sous-jacent ; et
- dans chaque ouverture 133d, une métallisation de contact de drain ou de source 137d spécifique au transistor sous-jacent.

Les métallisations 137a, 137b, 137c, 137d peuvent être formées simultanément. Les modes de réalisation décrits ne se limitent toutefois pas à ce cas particulier. Les métallisations 137a, 137b, 137c, 137d peuvent être formées avant, en même temps que, ou après la métallisation 135.

La figure 9 illustre en outre une étape optionnelle de formation, dans chaque pixel, sur la face supérieure de la couche diélectrique 125, d'un élément conducteur de connexion 139, par exemple une piste métallique, connectant la métallisation de contact d'anode 137a du pixel à une métallisation de contact de source ou de drain 137b d'un transistor MOS de la cellule élémentaire de contrôle du pixel. L'élément de connexion 139 est par exemple une piste de cuivre disposée sur la face supérieure de l'assemblage, en contact, par sa face inférieure, d'une part avec la face supérieure de la métallisation 137a et d'autre part avec la face supérieure de la métallisation 137b.

D'autres pistes conductrices d'interconnexion (non représentées) peuvent être prévues pour, dans chaque pixel, connecter une ou plusieurs métallisations de contact du pixel à un circuit périphérique ou externe de commande du dispositif.

Le dispositif d'affichage ainsi réalisé est destiné à émettre de la lumière par sa face inférieure. A titre d'exemple, le substrat 101 est un substrat transparent, par exemple en saphir, ce qui permet de ne pas bloquer le passage de la lumière. A titre de variante, dans le cas où le substrat 101 n'est pas transparent, ce dernier peut être retiré. Une poignée de support, par exemple sous la forme d'un substrat de silicium, peut éventuellement être solidarisée à la face supérieure de l'assemblage avant le retrait du substrat 101, pour assurer la tenue mécanique de l'ensemble.

Un avantage du procédé de fabrication décrit en relation avec les figures 1 à 9 est qu'il présente un nombre d'étapes réduit, notamment par rapport aux procédés décrits dans les demandes de brevet susmentionnées.

Par rapport au procédé décrit dans la demande de brevet français FR 3 065 322 A1 susmentionnée, un avantage est que le report de la couche semiconductrice 115 sur la face supérieure de l'empilement actif de LED est simplifié par le fait que l'empilement actif de LED n'a pas encore été structuré au moment du report. Il est en particulier possible de réaliser le report avec une couche diélectrique d'interface (empilement des couches 113 et 117) d'épaisseur très faible, par exemple inférieure à 50 nm.

De plus, dans le procédé décrit ci-dessus, le budget thermique pour la réalisation du circuit de contrôle n'est pas limité par les éléments de connexion des LED comme c'est le cas dans la demande de brevet français FR 3 065 322 A1 susmentionnée, mais uniquement par la stabilité de l'empilement actif de LED.

Bien que l'on ait décrit ci-dessus un exemple de réalisation dans lequel le circuit électronique de contrôle des LED est réalisé dans un unique niveau semiconducteur, correspondant à la couche semiconductrice 115, les modes de réalisation décrits ne se limitent pas à ce cas particulier. A titre de variante, un deuxième niveau semiconducteur peut être prévu au-dessus de la couche diélectrique 125, dans lequel sont réalisés d'autres éléments du circuit de contrôle des LED. Dans ce cas, les transistors à plus haute tension d'alimentation du circuit de contrôle sont de préférence réalisés dans le premier niveau semiconducteur (i.e. au plus proche des LED), les transistors à plus basse tension d'alimentation pouvant être situés dans le deuxième niveau semiconducteur. Le deuxième niveau conducteur peut être réalisé en technologique dite 3D séquentielle, de façon similaire à ce qui a été décrit ci-dessus pour la réalisation du premier niveau, c'est-à-dire par dépôt ou report d'une couche semiconductrice additionnelle sur la face supérieure de la couche diélectrique 125, puis réalisation de transistors MOS dans et sur la couche semiconductrice additionnelle. A titre de variante, le deuxième niveau conducteur peut être réalisé en technologique dite 3D parallèle, c'est-à-dire réalisé séparément du dispositif de la figure 9, puis hybridé avec la face supérieure du dispositif de la figure 9.

Par ailleurs, les modes de réalisation décrits ne se limitent pas à l'exemple particulier d'ordonnancement des étapes du procédé décrit en relation avec les figures 1 à 9. On notera en particulier que, en variante, les tranchées 130 peuvent être formées entre l'étape de report de la couche semiconductrice 115 de la figure 3 et les étapes de formation des transistors MOS des figures 4 et 5, ou encore après ou en même temps que les étapes de formation des métallisations de contact 137a, 137b, 137c et 137d des pixels.

De plus, à titre de variante, la couche métallique 111 intermédiaire entre les couches semiconductrices 107 et 115 peut être omise. Dans ce cas, la couche de collage 113 est déposée directement sur la couche 107, et la métallisation de reprise de contact sur la couche 107 est localisée à l'intérieur de l'ouverture 133a (figure 8). Ceci permet de relâcher la contrainte de budget thermique sur le transistor MOS supérieur.

On notera de plus qu'une ou plusieurs étapes d'implantation localisées (par lithographie) d'éléments dopants dans une ou plusieurs des couches semiconductrices de l'empilement 100 peuvent éventuellement être prévues avant le report de la couche semiconductrice 115.

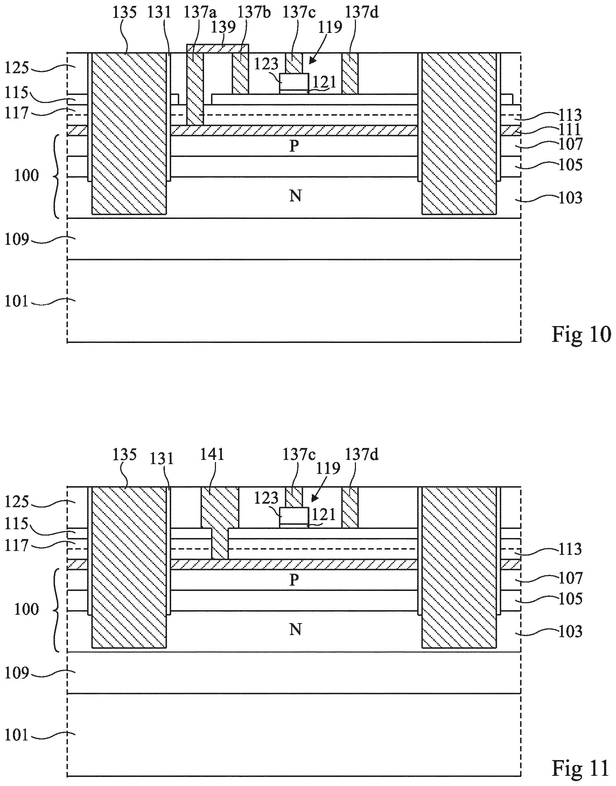

La figure 10 est une vue en coupe illustrant de façon schématique une première variante de réalisation du procédé des figures 1 à 9.

La variante de la figure 10 diffère du procédé des figures 1 à 9 principalement en ce que, dans cette variante, le motif d'isolation des transistors MOS formés dans et sur la couche semiconductrice 115 et le motif d'isolation des LED sont auto-alignés. Autrement dit, dans la variante de la figure 10, il n'est pas prévu de délimiter des caissons semiconducteurs dans la couche 115 préalablement à la formation des tranchées 130, comme décrit précédemment en relation avec la figure 4. Ainsi, dans la variante de la figure 10, lors de l'étape de gravure localisée de la couche semiconductrice 115 (figure 4), la couche 115 est retirée uniquement dans les zones de formation ultérieure des ouvertures 133a.

Dans la variante de la figure 10, dans chaque pixel, tous les transistors MOS du pixel formés dans et sur la couche semiconductrice 115 partagent une même zone active. La dimension des pixels peut ainsi être réduite. A titre d'exemple, dans la variante de la figure 10, dans chaque pixel, un unique transistor MOS à haute tension d'alimentation, par exemple de tension d'alimentation comprise entre 3 et 15 volts, est formé dans et sur la portion de couche semiconductrice 115 du pixel, ce transistor occupant sensiblement la même surface que la LED du pixel. Chaque pixel peut en outre comprendre des transistors à plus basse tension d'alimentation, par exemple de tension d'alimentation comprise entre 0,5 et 5 volts, formés dans un deuxième niveau semiconducteur (non représenté), au-dessus de la couche semiconductrice 115.

La figure 11 est une vue en coupe illustrant de façon schématique une deuxième variante de réalisation du procédé des figures 1 à 9.

La variante de la figure 11 diffère du procédé des figures 1 à 9 principalement en ce que, dans cette variante, dans chaque pixel, au lieu de prévoir une métallisation de contact d'anode 137a et une métallisation de contact de source ou drain 137b connectées par une piste conductrice 139, on prévoit une unique métallisation de contact partagée 141 traversant la couche semiconductrice 115 et connectant la région de source ou drain du transistor MOS à la couche conductrice de contact d'anode 111 du pixel.

Dans cette variante, la couche semiconductrice 115 n'est pas retirée dans la zone de formation de la métallisation de contact partagée 141 à l'étape de la figure 4.

La formation de la métallisation de contact partagée 141 comprend par exemple les étapes successives suivantes (non détaillées sur la figure 11) :
- former, à partir de la face supérieure de la couche diélectrique 125, une première ouverture s'étendant verticalement jusqu'à la face supérieure de la couche semiconductrice 115 (de préférence sur une région préalablement siliciurée de la face supérieure de la couche 115) ;
- former sur les parois latérales de la première ouverture des espaceurs en un matériau sacrificiel ;
- prolonger la première ouverture par une deuxième ouverture de dimension latérale réduite (du fait de la présence des espaceurs sacrificiels) traversant la couche semiconductrice 115 et s'étendant verticalement jusqu'à la face supérieure de la couche de contact d'anode 111 ;
- retirer les espaceurs sacrificiels ;
- remplir les première et deuxième ouvertures par du métal, par exemple du tungstène, pour former la métallisation 141.

La métallisation 141 ainsi réalisée est en contact avec la face supérieure de la couche semiconductrice 115 au fond de la première ouverture, et avec la face supérieure de la couche de contact d'anode 111 au fond de la deuxième ouverture.

A titre de variante (non représentée), l'ouverture dans laquelle est disposée la métallisation 141 peut être formée en une seule étape, auquel cas la métallisation 141 est en contact avec la couche semiconductrice 115 uniquement par les flancs de la couche 115.

La variante de la figure 11 permet de gagner en densité d'intégration des pixels.

On notera que les variantes des figures 10 et 11 peuvent être combinées, comme l'illustre la figure 11. Dans ce cas, l'étape de gravure localisée de la couche semiconductrice 115 de la figure 4 peut être omise. A titre de variante, la métallisation de contact partagée 141 décrite en relation avec la figure 11 peut être prévue dans un dispositif du type représenté en figure 9, c'est-à-dire dans lequel le motif d'isolation des transistors MOS formés dans et sur la couche semiconductrice 115 et le motif d'isolation des LED ne sont pas auto-alignés.

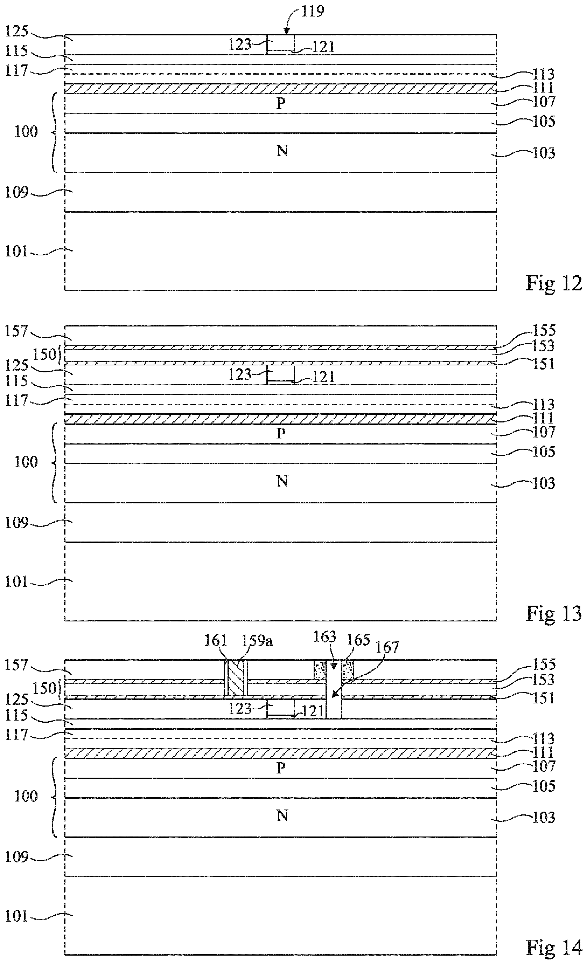

Les figures 12 à 18 sont des vues en coupe illustrant des étapes successives d'une troisième variante de réalisation du procédé des figures 1 à 9.

Dans cette troisième variante, on prévoit d'intégrer dans la cellule élémentaire de chaque pixel un condensateur connecté entre la grille et la source ou le drain d'un transistor MOS du pixel.

Les étapes initiales du procédé sont identiques ou similaires à celles décrites ci-dessus en relation avec les figures 1 à 6, à la différence près que, dans cet exemple, après le dépôt de la couche diélectrique 125 (figure 5), cette dernière est planarisée et amincie, par exemple par polissage mécano-chimique, jusqu'à libérer l'accès à la face supérieure de la couche conductrice de grille 123 des transistors MOS. A l'issue de cette étape, les grilles conductrices 123 affleurent au niveau de la face supérieure de la couche diélectrique 125.

La figure 12 illustre la structure obtenue à l'issue de l'étape de planarisation de la couche diélectrique 125. Dans l'exemple représenté, l'étape de gravure localisée de la couche semiconductrice 115 a été omise, et seules les grilles 119 ont été structurées. Autrement dit, à ce stade, la couche semiconductrice 115 s'étend de façon continue sur sensiblement toute la surface du dispositif. Les modes de réalisation décrits ne se limitent toutefois pas à ce cas particulier.

La figure 13 illustre une étape de dépôt d'un empilement métal-isolant-métal (MIM) 150 sur la face supérieure de la structure de la figure 12. L'empilement 150 comprend plus particulièrement une couche métallique inférieure 151, par exemple en nitrure de titane (TiN), une couche isolante intermédiaire 153, par exemple en oxyde d'hafnium (HfO₂), sur et en contact avec la face supérieure de la couche métallique 151, et une couche métallique supérieure 155, par exemple en oxyde de tantale (Ta₂O₅), sur et en contact avec la face supérieure de la couche isolante 153. La couche métallique inférieure 151 est en contact, par sa face inférieure, avec la face supérieure de la structure de la figure 12, et notamment avec la face supérieure des grilles conductrices 123 des transistors MOS du dispositif. A ce stade, chacune des couches 151, 153 et 155 de l'empilement MIM 150 s'étend de façon continue et sur une épaisseur sensiblement constante sur sensiblement toute la surface supérieure du dispositif.

La figure 13 illustre en outre une étape de dépôt d'une couche isolante de protection 157, par exemple en oxyde de silicium, sur la face supérieure de l'empilement MIM 150, par exemple en contact avec la face supérieure de la couche métallique 155.

La figure 14 illustre une étape de formation, dans chaque pixel, d'une première métallisation de contact 159a en contact avec la couche métallique inférieure 151 de l'empilement MIM 150 et donc avec la grille conductrice 123 du pixel (par l'intermédiaire de la couche métallique 151). La métallisation 159a s'étend verticalement depuis la face supérieure de la couche diélectrique 157 jusqu'à la face supérieure de la couche métallique 151, et est isolée latéralement de la couche métallique supérieure 155 de l'empilement MIM 150 par une couche isolante 161.

La formation de la métallisation 159a comprend par exemple les étapes successives suivantes (non détaillées sur la figure) :
- former une ouverture s'étendant verticalement depuis la face supérieure de la couche diélectrique 157 jusqu'à la face supérieure de la couche métallique 151, à travers les couches 157, 155 et 153 ;
- déposer une couche isolante 161, par exemple en oxyde de silicium, revêtant les parois latérales et le fond de l'ouverture, puis retirer la couche isolante 161 au fond de l'ouverture, par exemple par gravure anisotrope verticale, de façon à ne conserver la couche 161 que sur les parois latérales de l'ouverture ; et
- remplir l'ouverture de métal, par exemple de tungstène, pour former la métallisation 159a.

On notera que la métallisation 159a n'est pas nécessairement à l'aplomb de la grille conductrice 123 d'un transistor MOS du pixel, mais peut être déportée par rapport à la grille, comme représenté en figure 14. A titre de variante, la métallisation 159a peut être située à l'aplomb de la grille 123.

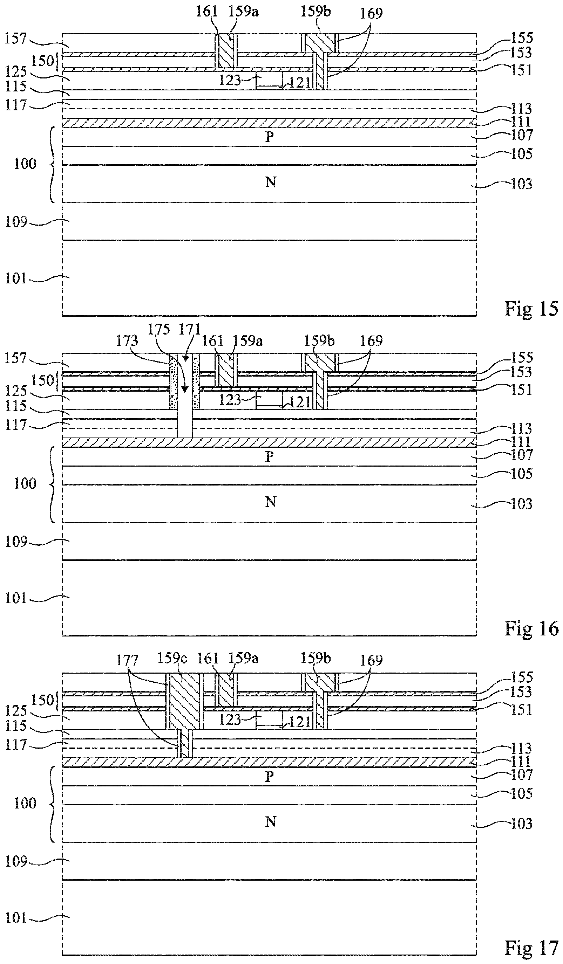

La figure 14 illustre en outre des étapes en vue de la formation d'une métallisation de contact 159b (figure 15) partagée entre la couche métallique supérieure 155 de l'empilement MIM 150 et une région de source ou de drain du transistor MOS du pixel.

La figure 14 illustre plus particulièrement les étapes successives suivantes (non détaillées sur la figure) :
- formation d'une première ouverture 163 s'étendant verticalement depuis la face supérieure de la couche diélectrique 157 jusqu'à la face supérieure de la couche métallique 155 ;
- formation d'espaceurs 165 en un matériau sacrificiel sur les parois latérales de l'ouverture 163 ; et
- prolongement de l'ouverture 163 par une deuxième ouverture 167 de dimension latérale réduite (du fait de la présence des espaceurs 165) traversant les couches 155, 153, 151 et 125 et débouchant sur la face supérieure de la couche semiconductrice 115, au niveau d'une région de contact de source ou de drain du transistor (de préférence préalablement siliciurée pour faciliter le contrôle de la gravure et favoriser la reprise du contact électrique de source ou de drain).

La figure 15 illustre la formation de la métallisation de contact 159b proprement dite, comprenant les étapes successives suivantes (non détaillées sur la figure) :
- retirer les espaceurs sacrificiels 165 ;
- déposer une couche isolante 169, par exemple en oxyde de silicium, d'épaisseur inférieure à celle des espaceurs sacrificiels 165, sur les parois latérales et sur le fond des ouvertures 163 et 167 ;
- retirer la couche isolante 169 sur le fond des ouvertures 163 et 167, par exemple par gravure anisotrope verticale, de façon à ne conserver la couche 169 que sur les parois latérales des ouvertures 163 et 167 ; et
- remplir les ouvertures 163 et 167 de métal, par exemple de tungstène, pour former la métallisation 159b.

La métallisation 159b est ainsi en contact avec la couche métallique supérieure de l'empilement MIM 150, au fond de l'ouverture 163, et avec la couche semiconductrice 115, au fond de l'ouverture 165, et est isolée de la couche conductrice inférieure 151 de l'empilement MIM 150 par la couche d'isolation latérale 169.

La figure 16 illustre des étapes en vue de la formation d'une métallisation de contact 159c (figure 17) partagée entre la couche semiconductrice 115, au niveau d'une région de drain ou de source du transistor MOS du pixel, et la couche de contact d'anode 111 du pixel.

La figure 16 illustre plus particulièrement les étapes successives suivantes (non détaillées sur la figure) :
- formation d'une première ouverture 171 s'étendant verticalement depuis la face supérieure de la couche diélectrique 157 jusqu'à la face supérieure de la couche semiconductrice 115, au niveau d'une région de contact de drain ou de source du transistor (de préférence préalablement siliciurée) ;
- formation d'espaceurs 173 en un matériau sacrificiel sur les parois latérales de l'ouverture 171 ; et
- prolongement de l'ouverture 171 par une deuxième ouverture 175 de dimension latérale réduite (du fait de la présence des espaceurs 173) traversant les couches 115, 117 et 113 et débouchant sur la face supérieure de la couche métallique de contact d'anode 111 du pixel.

La figure 17 illustre la formation de la métallisation de contact 159c proprement dite, comprenant les étapes successives suivantes (non détaillées sur la figure) :
- retirer les espaceurs sacrificiels 173 ;
- déposer une couche isolante 177, par exemple en oxyde de silicium, d'épaisseur inférieure à celle des espaceurs sacrificiels 173, sur les parois latérales et sur le fond des ouvertures 171 et 175 ;
- retirer la couche isolante 177 sur le fond des ouvertures 171 et 175, par exemple par gravure anisotrope verticale, de façon à ne conserver la couche 177 que sur les parois latérales des ouvertures 171 et 175 ; et
- remplir les ouvertures 171 et 175 de métal, par exemple de tungstène, pour former la métallisation 159c.

La métallisation 159c est ainsi en contact avec la couche semiconductrice 115 au fond de l'ouverture 171 et avec la couche métallique de contact d'anode 111 au fond de l'ouverture 175, et est isolée des couches métalliques 151 et 155 de l'empilement MIM 150 par la couche d'isolation latérale 177.

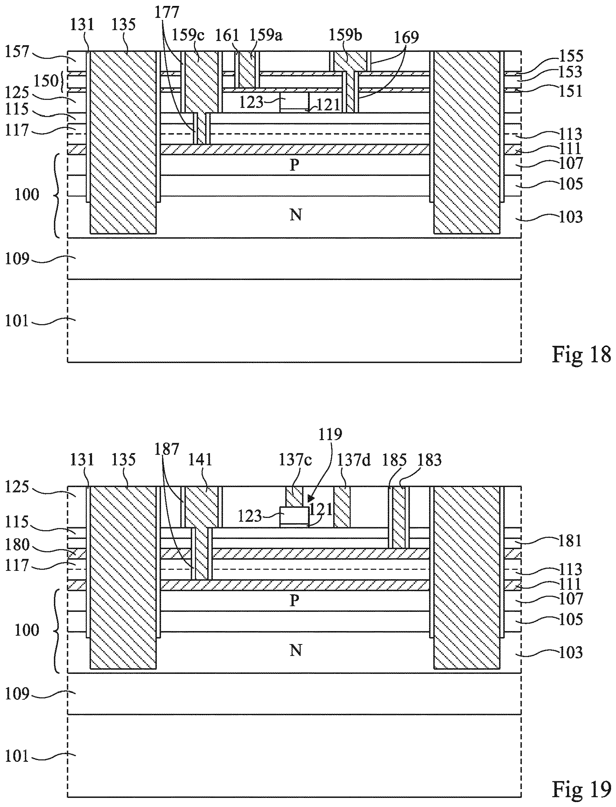

La figure 18 illustre la formation d'une métallisation de contact de cathode 135 commune à tous les pixels du capteur, disposée dans des tranchées s'étendant verticalement depuis la face supérieure de la couche diélectrique 157 jusqu'à un niveau intermédiaire dans la couche semiconductrice 103, et isolée latéralement des couches 151, 155, 115, 111, 107 et 105 par une couche d'isolation latérale 131. La métallisation de contact de cathode 135 peut être réalisée par un procédé similaire à ce qui a été décrit précédemment, à la différence près que, dans cette variante, les tranchées de délimitation des pixels traversent également l'empilement MIM 150.

Un avantage du procédé des figures 12 à 18 est qu'il permet de former, dans chaque pixel, un condensateur ayant une électrode inférieure 151 connectée à la grille conductrice 123 d'un transistor MOS du pixel, et une électrode supérieure 155 connectée à une région de source ou de drain de ce même transistor.

En fonction du schéma électrique souhaité de la cellule élémentaire de contrôle du pixel, ce procédé pourra être adapté pour réaliser plusieurs condensateurs distincts par pixel dans l'empilement MIM 150.

Par ailleurs, bien que l'on ait décrit ci-dessus un exemple de réalisation avantageux dans lequel les métallisations de contact 159b et 159c sont partagées, les modes de réalisation décrits ne se limitent pas à ce cas particulier. A titre de variante, l'une ou chacune des deux métallisations 159b et 159c peut être remplacée par deux métallisations distinctes reliées par une piste conductrice disposée sur la face supérieure de la couche diélectrique 157.

Par ailleurs, la variante de réalisation des figures 12 à 18 ne se limite pas à l'exemple illustré sur les figures dans lequel le motif d'isolation des transistors MOS formés dans et sur la couche semiconductrice 115 et le motif d'isolation des LED sont auto-alignés.

La figure 19 est une vue en coupe illustrant de façon schématique une quatrième variante de réalisation du procédé des figures 1 à 9.

La variante de la figure 19 diffère de ce qui a été décrit précédemment principalement en ce que le dispositif comprend en outre, dans chaque pixel, entre la couche conductrice de contact d'anode 111 et la couche semiconductrice 115, un plan de masse 180 formé par une couche d'un matériau conducteur ou semiconducteur, par exemple une couche de silicium polycristallin dopé. En fonctionnement, le plan de masse 180 est maintenu à un potentiel de référence du dispositif, par exemple la masse, et permet de découpler la LED de la cellule élémentaire de contrôle du pixel, et notamment d'éviter que les niveaux de tension relativement élevés appliqués sur la couche de contact d'anode de la LED n'induisent une modification du comportement du ou des transistors de la cellule élémentaire de contrôle du pixel.

Dans l'exemple représenté, le plan de masse 180 est disposé entre la couche diélectrique 117 et la couche semiconductrice 115, une couche diélectrique additionnelle 181, par exemple en oxyde de silicium, faisant interface entre le plan de masse 180 et la couche semiconductrice 115.

A titre d'exemple, le plan de masse 180 peut être rapporté sur la face supérieure de la couche isolante 113 en même temps que la couche semiconductrice 115, à l'étape de la figure 3. A titre de variante, le plan de masse 180 peut être déposé sur la face supérieure de la couche isolante 113 avant le report de la couche semiconductrice 115.

La suite du procédé est par exemple identique ou similaire à ce qui a été décrit précédemment, à ceci près que :
- la métallisation de reprise de contact sur la couche de contact d'anode 111 de la LED traverse le plan de masse 180 et doit donc être isolée du plan de masse 180 ; et
- chaque pixel comprend une métallisation de reprise de contact additionnelle 183 pour la polarisation du plan de masse 180.

Dans l'exemple représenté, la métallisation de reprise de contact additionnelle 183 traverse la couche semiconductrice 115 et est isolée de cette dernière par une couche isolante latérale 185, par exemple en oxyde de silicium.

De plus, dans cet exemple, la métallisation 141 de reprise de contact d'anode est une métallisation partagée avec la couche semiconductrice 115, similaire à ce qui a été décrit dans l'exemple de la figure 11. Toutefois, dans la variante de la figure 19, la métallisation 141 traverse le plan de masse 180 et est isolée de ce dernier par une couche isolante latérale 187, par exemple en oxyde de silicium.

La variante de la figure 19 pourra bien entendu être combinée avec toutes les variantes décrites précédemment.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas aux exemples de matériaux décrits ci-dessus, ni aux exemples de dimensions mentionnées ci-dessus.

De plus, les types de conductivité des couches semiconductrices 103 et 107 de l'empilement de LED 100 peuvent être inversés.

Par ailleurs, bien que l'on ait décrit uniquement des exemples de réalisation de dispositifs d'affichage à base de LED, les modes de réalisation décrits peuvent être adaptés à la fabrication d'un capteur comportant une pluralité de photodiodes, par exemple au nitrure de gallium, adressables individuellement pour acquérir une image.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semi-conducteurs III-V ou des diodes à base de silicium.

Les revendications qui suivent définissent l'objet de la protection.

## Revendications

1. Procédé de fabrication d'un dispositif optoélectronique, comportant les étapes suivantes :
a) prévoir un empilement actif de diode (100) comportant une première couche semiconductrice (103) dopée d'un premier type de conductivité et une deuxième couche semiconductrice (107) dopée du deuxième type de conductivité, revêtant la face supérieure de la première couche ;
b) disposer une troisième couche semiconductrice (115) sur la face supérieure de l'empilement actif (100) ; et
c) après l'étape b), former au moins un transistor MOS dans et sur la troisième couche semiconductrice (115),
le procédé étant **caractérisé en ce qu'**il comporte, en outre, l'étape suivante:
d) après l'étape b), avant ou après l'étape c), former des tranchées (130) s'étendant verticalement à travers un plan correspondant à la troisième couche (115), ou directement à travers la troisième couche (115), et débouchant dans la première couche (103), ou sur la face supérieure de la première couche (103), et délimitant une pluralité de pixels comprenant chacun une diode et une cellule élémentaire de contrôle de la diode.

2. Procédé selon la revendication 1, dans lequel, en vue de dessus, les tranchées (130) forment une grille continue séparant les uns des autres les pixels du dispositif.

3. Procédé selon la revendication 2, comprenant en outre une étape de remplissage des tranchées (130) par du métal de façon à former une métallisation (135) de contact avec la première couche semiconductrice (103), commune à tous les pixels du dispositif.

4. Procédé selon la revendication 3, dans lequel, avant le remplissage des tranchées (130) par du métal, une couche d'isolation (131) est déposée sur les parois latérales des tranchées.

5. Procédé selon l'une quelconque des revendications 1 à 4, dans lequel, après l'étape b) et avant l'étape d), la troisième couche semiconductrice (115) est retirée dans les zones de formation des tranchées (130).

6. Procédé selon l'une quelconque des revendications 1 à 4, dans lequel la troisième couche semiconductrice (115) n'est pas retirée dans les zones de formation des tranchées (130) avant l'étape d).

7. Procédé selon l'une quelconque des revendications 1 à 6, comprenant en outre, après l'étape b), une étape de formation, dans chaque pixel, d'une métallisation de contact (137a ; 141 ; 159c) avec la deuxième couche semiconductrice (107), et d'une métallisation de contact (137b ; 141 ; 159c) avec la troisième couche semiconductrice (115).

8. Procédé selon la revendication 7, dans lequel la métallisation de contact (137a) avec la deuxième couche semiconductrice (107) et la métallisation de contact (137b) avec la troisième couche semiconductrice (115) sont des métallisations distinctes, connectées l'une à l'autre par une piste conductrice (139) en contact avec les faces supérieures desdites métallisations.

9. Procédé selon la revendication 7, dans lequel la métallisation de contact (141 ; 159c) avec la deuxième couche semiconductrice (107) et la métallisation de contact (141 ; 159c) avec la troisième couche conductrice (115) sont confondues et sont disposées dans une même ouverture traversant la troisième couche semiconductrice (115) .

10. Procédé selon l'une quelconque des revendications 1 à 9, comprenant en outre, après l'étape c), une étape de dépôt d'un empilement métal-isolant-métal (150), une couche métallique inférieure (151) de l'empilement métal-isolant-métal étant en contact avec une grille conductrice (123) dudit au moins un transistor MOS.

11. Procédé selon la revendication 10, comprenant en outre une étape de formation, dans chaque pixel, d'une métallisation (159b) en contact à la fois avec une couche métallique supérieure (155) de l'empilement métal-isolant-métal (150) et avec la troisième couche semiconductrice (115).

12. Procédé selon l'une quelconque des revendications 1 à 11, comprenant en outre, avant l'étape c), la formation d'un plan de masse (180) conducteur ou semiconducteur entre la deuxième couche semiconductrice (107) et la troisième couche semiconductrice (115), le plan de masse (180) étant isolé des deuxième (107) et troisième (115) couches semiconductrices.

13. Procédé selon la revendication 12, comprenant une étape de formation, dans chaque pixel, d'une métallisation de contact (183) avec le plan de masse (180), ladite métallisation étant disposée dans une ouverture traversant la troisième couche semiconductrice (115).

14. Procédé selon l'une quelconque des revendications 1 à 13, dans lequel les diodes sont des diodes électroluminescentes.

15. Procédé selon l'une quelconque des revendications 1 à 14, dans lequel les première (103) et deuxième (107) couches semiconductrices sont des couches à base de matériaux semiconducteurs III-V, et la troisième couche semiconductrice (115) est en silicium.

16. Procédé selon l'une quelconque des revendications 1 à 15, comprenant en outre, après l'étape c), une étape de disposition d'une quatrième couche semiconductrice sur la face supérieure de la troisième couche semiconductrice (115).

17. Procédé selon l'une quelconque des revendications 1 à 16, dans lequel, à l'étape c), la température de formation du transistor MOS ne dépasse pas 500°C.

## Patentansprüche

1. Ein Verfahren zur Herstellung eines optoelektronischen Einrichtung, das die folgenden Schritte aufweist:
a) Bereitstellen eines aktiven Diodenstapels (100), der eine erste dotierte Halbleiterschicht (103) eines ersten Leitfähigkeitstyps und eine zweite dotierte Halbleiterschicht (107) des zweiten Leitfähigkeitstyps aufweist, wobei die obere Fläche der ersten Schicht beschichtet wird;
b) Anordnen einer dritten Halbleiterschicht (115) auf der oberen Fläche des aktiven Stapels (100); und
c) nach Schritt b) Ausbilden mindestens eines MOS-Transistors innerhalb und auf der Oberseite der dritten Halbleiterschicht (115),
wobei das Verfahren **dadurch gekennzeichnet ist, dass** es außerdem den folgenden Schritt aufweist:
d) nach dem Schritt b), vor oder nach dem Schritt c), Bilden von Gräben (130), die sich vertikal durch eine der dritten Schicht (115) entsprechende Ebene oder direkt durch die dritte Schicht (115) erstrecken und in die erste Schicht (103) oder auf die Oberseite der ersten Schicht (103) münden und eine Vielzahl von Pixeln abgrenzen, die jeweils eine Diode und eine elementare Diodensteuerzelle aufweisen.

2. Verfahren nach Anspruch 1, wobei die Gräben (130) in der Draufsicht ein durchgehendes Gate bilden, das die Einrichtungspixel voneinander trennt.

3. Verfahren nach Anspruch 2, das ferner einen Schritt des Füllens der Gräben (130) mit Metall aufweist, um eine Metallisierung (135) des Kontakts mit der ersten Halbleiterschicht (103) zu bilden, die allen Pixeln der Einrichtung gemeinsam ist.

4. Verfahren nach Anspruch 3, wobei vor dem Füllen der Gräben (130) mit Metall eine Isolierschicht (131) auf den Seitenwänden der Gräben abgeschieden wird.

5. Verfahren nach Anspruch 1, wobei nach Schritt b) und vor Schritt d) die dritte Halbleiterschicht (115) von den grabenbildenden Bereichen (130) entfernt wird.

6. Verfahren nach Anspruch 1, wobei die dritte Halbleiterschicht (115) nicht vor Schritt d) aus den grabenbildenden Bereichen (130) entfernt wird.

7. Verfahren nach Anspruch 1, wobei das Verfahren weiterhin nach Schritt b) einen Schritt des Bildens einer Metallisierung (137a; 141; 159c) in Kontakt mit der zweiten Halbleiterschicht (107) und einer Metallisierung (137b; 141; 159c) in Kontakt mit der dritten Halbleiterschicht (115) in jedem Pixel aufweist.

8. Verfahren nach Anspruch 7, wobei die Metallisierung (137a), die mit der zweiten Halbleiterschicht (107) in Kontakt steht, und die Metallisierung (137b), die mit der dritten Halbleiterschicht (115) in Kontakt steht, getrennte Metallisierungen sind, die durch eine Leiterbahn (139) in Kontakt mit den oberen Oberflächen der Metallisierungen miteinander verbunden sind.

9. Verfahren nach Anspruch 7, wobei die Metallisierung (141; 159c) in Kontakt mit der zweiten Halbleiterschicht (107) und die Metallisierung (141; 159c) in Kontakt mit der dritten leitenden Schicht (115) zusammengenommen werden und in einer gleichen Öffnung angeordnet sind, die die dritte Halbleiterschicht (115) kreuzt.

10. Verfahren nach Anspruch 1, das ferner nach Schritt c) einen Schritt des Abscheidens eines Metall-Isolator-Metall-Stapels (150) aufweist, wobei eine untere Metallschicht (151) des Metall-Isolator-Metall-Stapels in Kontakt mit einem leitenden Gate (123) des mindestens einen MOS-Transistors steht.

11. Verfahren nach Anspruch 10, das ferner einen Schritt der Bildung, in jedem Pixel, einer Metallisierung (159b) in Kontakt sowohl mit einer oberen Metallschicht (155) des Metall-Isolator-Metall-Stapels (150) als auch mit der dritten Halbleiterschicht (115) aufweist.

12. Verfahren nach Anspruch 1, das ferner vor Schritt c) das Bilden einer leitenden oder halbleitenden Masseebene (180) zwischen der zweiten Halbleiterschicht (107) und der dritten Halbleiterschicht (115) aufweist, wobei die Masseebene (108) von der zweiten (107) und dritten (115) Halbleiterschicht isoliert ist.

13. Verfahren nach Anspruch 12, das einen Schritt zur Bildung einer Kontaktmetallisierung (183) mit der Masseebene (180) in jedem Pixel aufweist, wobei die Metallisierung in einer die dritte Halbleiterschicht (115) kreuzenden Öffnung angeordnet ist.

14. Verfahren nach Anspruch 1, wobei die Dioden lichtemittierende Dioden sind.

15. Verfahren nach Anspruch 1, wobei die erste (103) und die zweite (107) Halbleiterschicht Schichten sind, die aus III-V-Halbleitermaterialien bestehen, und die dritte Halbleiterschicht (115) aus Silizium hergestellt ist.

16. Verfahren nach Anspruch 1, das ferner nach Schritt c) einen Schritt des Anordnens einer vierten Halbleiterschicht auf der oberen Oberfläche der dritten Halbleiterschicht (115) aufweist.

17. Verfahren nach Anspruch 1, wobei in Schritt c) die MOS-Transistorbildungstemperatur 500°C nicht überschreitet.

## Claims

1. A method of manufacturing an optoelectronic device, comprising the steps of:
a) providing an active diode stack (100) comprising a first doped semiconductor layer (103) of a first conductivity type and a second doped semiconductor layer (107) of the second conductivity type, coating the upper surface of the first layer;
b) arranging a third semiconductor layer (115) on the upper surface of the active stack (100); and
c) after step b), forming at least one MOS transistor inside and on top of the third semiconductor layer (115),
the method being **characterized in that** it further comprises the following step:
d) after step b), before or after step c), forming trenches (130) vertically extending through a plane corresponding to the third layer (115), or directly through the third layer (115), and emerging into the first layer (103), or onto the upper surface of the first layer (103), and delimiting a plurality of pixels, each comprising a diode and an elementary diode control cell.

2. The method of claim 1, wherein, in top view, the trenches (130) form a continuous gate separating from one another the device pixels.

3. The method of claim 2, further comprising a step of filling the trenches (130) with metal to form a metallization (135) of contact with the first semiconductor layer (103), common to all the pixels of the device.

4. The method of claim 3, wherein, before the filling of the trenches (130) with metal, an insulation layer (131) is deposited on the lateral walls of the trenches.

5. The method of claim 1, wherein, after step b) and before step d), the third semiconductor layer (115) is removed from the trench-forming areas (130).

6. The method of claim 1, wherein the third semiconductor layer (115) is not removed from the trench-forming areas (130) before step d).

7. The method of claim 1, further comprising, after step b), a step of forming, in each pixel, a metallization (137a; 141; 159c) of contact with the second semiconductor layer (107), and a metallization (137b; 141; 159c) of contact with the third semiconductor layer (115).

8. The method of claim 7, wherein the metallization (137a) of contact with the second semiconductor layer (107) and the metallization (137b) of contact with the third semiconductor layer (115) are distinct metallizations, connected to each other by a conductive track (139) in contact with the upper surfaces of said metallizations.

9. The method of claim 7, wherein the metallization of contact (141; 159c) with the second semiconductor layer (107) and the metallization of contact (141; 159c) with the third conductive layer (115) are confounded and are arranged in a same opening crossing the third semiconductor layer (115) .

10. The method of claim 1, further comprising, after step c), a step of depositing a metal-insulator-metal stack (150), a lower metal layer (151) of the metal-insulator-metal stack being in contact with a conductive gate (123) of said at least one MOS transistor.

11. The method of claim 10, further comprising a step of forming, in each pixel, a metallization (159b) in contact both with an upper metal layer (155) of the metal-insulator-metal stack (150) and with the third semiconductor layer (115).

12. The method of claim 1, further comprising, before step c), the forming of a conductive or semiconductor ground plane (180) between the second semiconductor layer (107) and the third semiconductor layer (115), the ground plane (108) being insulated from the second (107) and third (115) semiconductor layers.

13. The method of claim 12, comprising a step of forming, in each pixel, a metallization of contact (183) with the ground plane (180), said metallization being arranged in an opening crossing the third semiconductor layer (115).

14. The method of claim 1, wherein the diodes are light-emitting diodes.

15. The method of claim 1, wherein the first (103) and second (107) semiconductor layers are layers made up of III-V semiconductor materials, and the third semiconductor layer (115) is made of silicon.

16. The method of claim 1, further comprising, after step c), a step of arranging a fourth semiconductor layer on the upper surface of the third semiconductor layer (115).

17. The method of claim 1, wherein, at step c), the MOS transistor forming temperature does not exceed 500°C.
